# EUROPÄISCHE PATENTANMELDUNG

(11) **EP 4 734 374 A2**
(43) Veröffentlichungstag der Anmeldung: **29.04.2026**
(21) Anmeldenummer: 25199310.1
(22) Anmeldetag: 01.09.2025
(51) Int. Cl.: H03K 17/96

(54) **BEDIENVORRICHTUNG FÜR EIN ELEKTROGERÄT UND ELEKTROGERÄT MIT EINER SOLCHEN BEDIENVORRICHTUNG**

(30) Priorität: 01.10.2024 DE 102024128347
(71) Anmelder: E.G.O. Elektro-Gerätebau GmbH, 75038 Oberderdingen (DE)
(72) Erfinder: Frank, Andreas, 75015 Bretten (DE)
(74) Vertreter: Patentanwälte Ruff, Wilhelm, Beier, Dauster & Partner mbB

(57) **Zusammenfassung**

Eine Bedienvorrichtung für ein Elektrogerät weist eine flächig ausgebildete lichtdurchlässige Bedienblende mit Vorderseite und Rückseite auf, einen Bedienbereich an der Bedienblende, in dem kapazitive Berührsensoren angeordnet sind, die das Berühren an der Vorderseite der Bedienblende im Bedienbereich mittels eines Fingers an einer bestimmten Stelle erkennen, und mindestens eine Leuchtanzeige in dem Bedienbereich unterhalb der Berührsensoren zur Anzeige eines Symbols oder möglichen Bedienbefehls, der durch Berühren der Vorderseite der Bedienblende mit dem Finger betätigt oder ausgewählt wird. Die Berührsensoren können nach dem Prinzip des kapazitiven Übersprechens oder als kapazitive Berührsensoren arbeitend ausgebildet sein, wobei sie in einem Raster an der Rückseite der Bedienblende im Bedienbereich angeordnet sind.

## Beschreibung

### Anwendungsgebiet und Stand der Technik

Die Erfindung betrifft eine Bedienvorrichtung für ein Elektrogerät sowie ein mit einer solchen Bedienvorrichtung versehenes Elektrogerät, wobei die Bedienvorrichtung mit einer Bedienblende an der Außenseite des Elektrogeräts angeordnet ist.

Aus der EP 1 158 838 A1 ist eine Bedienvorrichtung für ein Kochfeld bekannt, die eine flächig ausgebildete Bedienblende aufweist, um auf deren Fläche das Berühren der Vorderseite der Bedienblende mittels eines Fingers an einer bestimmten Stelle zu erkennen. Dafür sind in den vier Ecken einer rechteckigen Fläche der Bedienblende kapazitive Sensoren angeordnet. Durch Bestimmung der Entfernung einer Stelle, an der ein Finger die Bedienblende berührt, zu jedem der vier Sensoren kann der Ort dieser Stelle bestimmt werden. So kann eine diesem Ort zugeordnete und mit einer bestimmten Bedeutung versehene Bedienfunktion, die durch ein Symbol odgl. angezeigt wird, ausgelöst werden.

Eine weitere Bedienvorrichtung für ein Kochfeld ist aus der EP 2 395 813 A1 bekannt. Kapazitive Berührsensoren sind aus der EP 0 859 467 A1 bekannt.

### Aufgabe und Lösung

Der Erfindung liegt die Aufgabe zugrunde, eine eingangs genannte Bedienvorrichtung für ein Elektrogerät sowie ein mit einer solchen Bedienvorrichtung versehenes Elektrogerät zu schaffen, mit denen Probleme des Standes der Technik vermieden werden können und es insbesondere möglich ist, die Bedienvorrichtung einfach und vielseitig verwendbar auszugestalten sowie betriebssicher auszubilden.

Gelöst wird diese Aufgabe durch eine Bedienvorrichtung mit den Merkmalen des Anspruchs 1 sowie durch ein mit einer solchen Bedienvorrichtung versehenes Elektrogerät mit den Merkmalen des Anspruchs 13. Vorteilhafte sowie bevorzugte Ausgestaltungen der Erfindung sind Gegenstand der weiteren Ansprüche und werden im Folgenden näher erläutert. Dabei werden manche der Merkmale nur für die Bedienvorrichtung oder nur für das Elektrogerät beschrieben. Sie sollen jedoch unabhängig davon sowohl für eine solche Bedienvorrichtung als auch für ein solches Elektrogerät selbständig und unabhängig voneinander gelten können. Der Wortlaut der Ansprüche wird durch ausdrückliche Bezugnahme zum Inhalt der Beschreibung gemacht.

Die Bedienvorrichtung weist eine flächig ausgebildete Bedienblende auf, welche eine Vorderseite und eine Rückseite aufweist. An der Vorderseite soll ein Finger aufgelegt werden. Vorteilhaft kann die Bedienblende rechteckig ausgebildet sein, muss dies aber nicht. Sie ist zumindest teilweise lichtdurchlässig ausgebildet, so dass Symbole oder Bilder mittels Beleuchten von hinten angezeigt werden können. An der Bedienblende ist ein Bedienbereich vorgesehen, in dem Berührsensoren angeordnet sind. Diese Berührsensoren sind derart ausgebildet, dass sie das Berühren an der Vorderseite der Bedienblende in dem genannten Bedienbereich, also wo ein Finger an einer bestimmten Stelle aufgelegt worden ist, erkennen können. Vorteilhaft sind die Berührsensoren kapazitiv ausgebildet, wozu nachfolgend noch mehr erläutert wird. Des Weiteren weist die Bedienvorrichtung mindestens eine Leuchtanzeige auf, die im Bedienbereich unterhalb der Berührsensoren bzw. unterhalb oder hinter der Bedienblende angeordnet ist. Sie dient dazu, ein Symbol oder einen möglichen Bedienbefehl oder eine Information anzuzeigen. Diese können dann durch Berühren an der Vorderseite der Bedienblende an dieser Stelle mit dem Finger betätigt oder ausgewählt werden, wie dies an sich von derartigen Bedienvorrichtungen oder Touchscreens bekannt ist.

Erfindungsgemäß sind die genannten Berührsensoren so ausgebildet, dass sie kapazitive Berührsensoren sind, wobei sie vorzugsweise so ausgebildet sind, dass sie nach dem Prinzip des kapazitiven Übersprechens oder als kapazitiver Berührsensor arbeiten. Die Bedienblende muss also nicht mechanisch eingedrückt werden oder verformt werden odgl.. Des Weiteren sind die Berührsensoren in einem Raster an der Rückseite der Bedienblende oder hinter der Bedienblende in dem genannten Bedienbereich angeordnet, beispielsweise in einem regelmäßigen Raster nach Art von Gitterlinien odgl.. Alternativ können sie als ineinander kämmende oder verschränkte längliche Streifen ausgebildet sein, beispielsweise ähnlich den Zungen eines Backgammon-Spiels.

Durch das genannte Vorsehen von Berührsensoren nicht nur in Ecken eines Bedienbereichs der Bedienvorrichtung, wie es für den eingangs genannten Stand der Technik beschrieben worden ist, kann eine genauere Erkennung einer Stelle des Berührens mit einem Finger erkannt werden. So können zum einen Fehlbedienungen besser vermieden werden, zum anderen können so unter Umständen näher verschiedene Berührstellen für unterschiedliche Funktionen vorgesehen sein, da eine Erfassung einer Stelle des Berührens mit dem Finger genauer möglich ist, als wenn in den Ecken des Berührbereichs Sensoren vorgesehen wären. Des Weiteren kann vorgesehen sein, dass die Berührsensoren nicht zwingend in einem regelmäßigen Raster angeordnet sind bzw. regelmäßig verteilt angeordnet sind, sondern in unterschiedlichen Bereichen, wo eine genauere Unterscheidung gewünscht ist, können mehr Berührsensoren gebildet sein bzw. mehr Berührsensoren angeordnet sein. Das Vorsehen von kapazitiven Berührsensoren weist den großen Vorteil auf, dass ein relativ großer Bedienbereich abgedeckt bzw. überwacht werden kann, weswegen sie gegenüber optischen Berührsensoren bevorzugt werden.

In Ausgestaltung der Erfindung können die Berührsensoren an einem flächigen Träger ausgebildet sein, insbesondere als Beschichtung, als Leiterbahnen odgl.. So können sie leicht hergestellt werden, insbesondere automatisiert, und benötigen keine Einzelteile wie beispielsweise gemäß der EP 0 859 467 A1, die bei Herstellung aufwendig einzeln platziert werden müssen. Dazu können die Berührsensoren bzw. Leiterbahnen auch lichtdurchlässig ausgebildet sein, so dass sie im Bedienbereich angeordnet sein können und dennoch nicht stören, insbesondere die Leuchtanzeige nicht beeinträchtigen. Unter Umständen können die Berührsensoren bzw. Leiterbahnen auf diese Weise sogar unsichtbar sein.

In einer ersten Möglichkeit einer Ausgestaltung der Erfindung können die Leiterbahnen in zwei Gruppen aufgeteilt sein, wobei die Leiterbahnen innerhalb jeder Gruppe jeweils parallel zueinander verlaufen. Alle Leiterbahnen einer Gruppe verlaufen also gleichartig und parallel, vorteilhaft mit konstanter Breite im Bedienbereich, wobei sie auch jeweils innerhalb der Gruppe gleichartig bzw. identisch ausgebildet sind. Die Leiterbahnen können bevorzugt innerhalb ihrer Gruppe auch gleichen Abstand zueinander aufweisen. Die zwei Gruppen von Leiterbahnen können vorteilhaft in einem Winkel zwischen 60° und 120° zueinander verlaufen, insbesondere in einem Winkel zwischen 85° und 95° zueinander. Besonders vorteilhaft kreuzen sich die Leiterbahnen der beiden Gruppen in einem rechten Winkel, so dass insgesamt eine Art Karo-Muster gebildet ist durch die Leiterbahnen, vorteilhaft als regelmäßiges Karo-Muster.

In Ausgestaltung der Erfindung können die Leiterbahnen einer Gruppe einen Abstand zueinander zwischen 0,1 mm und 20 mm aufweisen, insbesondere zwischen 0,8 mm oder 3 mm und 15 mm, vorzugsweise zwischen 1 mm und 6 mm. Damit lässt sich ein ausreichend großer Bedienbereich abdecken, beispielsweise mit einer Fläche zwischen 25 cm² und 150cm², ohne dass eine allzu große Zahl von Leiterbahnen bzw. Berührsensoren benötigt wird.

In einer zweiten Möglichkeit einer Ausgestaltung der Erfindung können die Leiterbahnen bzw. die Berührsensoren länglich ausgebildet sind und mit geringem Abstand nebeneinander verlaufen, wobei insbesondere die Berührsensoren wiederum in zwei Gruppen ausgebildet sind. Dabei verlaufen sie abwechselnd parallel zueinander in entgegengesetzten Richtungen, kämmen also sozusagen miteinander bzw. greifen fingerartig ineinander. Dabei wechseln sich die Berührsensoren der beiden Gruppen ab bzw. sind abwechselnd benachbart zueinander angeordnet. Dabei sind die Berührsensoren länglich ausgebildet und gehen bzw. ragen jeweils von einer Leiterbahnen ab. So bildet jede Leiterbahn einen elektrischen Anschluss an einen Berührsensor. Die Berührsensoren sind vorteilhaft als längliche und spitz zulaufende Dreiecke ausgebildet, die abwechselnd ineinandergreifen. Ihr Abstand zueinander kann dabei sehr gering sein, beispielsweise zwischen 0,1 mm und 2 mm. Er muss nur ihre elektrische Isolierung gegeneinander sicherstellen. Derartige Berührsensoren arbeiten dann als einzelne eigenständige kapazitive Berührsensoren, wie es beispielsweise der EP 0 859 467 A1 entspricht. Durch Vergleich der Signalstärken an mehreren benachbarten Berührsensoren kann der genaue Ort einer Berührung mit dem Finger an der Bedienblende über den Berührsensoren erfasst werden. Im Bedienbereich weisen die Berührsensoren vorteilhaft keine konstante Breite auf, sondern diese sollte streng monoton zunehmen oder abnehmen, was beispielsweise durch die vorgenannte Ausbildung als Dreiecke gut möglich ist. So kann auch entlang des Längsverlaufs eines Berührsensors der Ort der Berührung mit dem Finger an der Bedienblende bestimmt werden.

In Ausgestaltung der Erfindung weist der Träger einen Anschlussbereich auf, in dem die Leiterbahnen zu ihrem elektrischen Anschluss geführt sind. Dabei können sie insbesondere an Anschlussfelder auf einer Seite oder auf beiden Seiten des Trägers geführt sein, wobei Leiterbahnen immer auf derselben Seite des Trägers bleiben sollten. Die Anschlussfelder können dabei freiliegen und/oder an einem Randbereich des Trägers bzw. des Anschlussbereichs angeordnet sein, so dass sie gut erreichbar sind. Der Anschlussbereich ist vorteilhaft einstückig mit dem Träger ausgebildet, so ist eine Herstellung leicht möglich. Vor allem können dann auch die Leiterbahnen sehr gut vom Träger auf den Anschlussbereich geführt werden.

In weiterer Ausgestaltung der Erfindung ist der Anschlussbereich in einem Bereich des Trägers ausgebildet ist, der von dem Träger absteht. Der Anschlussbereich kann dabei rechteckig ausgebildet sein und als Rechteck von dem restlichen Träger abstehen. Der Träger selbst kann auch rechteckige Form aufweisen.

In Ausgestaltung der Erfindung kann der Träger eine Dicke von weniger als 1 mm aufweisen, vorzugsweise eine Dicke zwischen 0,05 mm und 0,2 mm. Er kann als eine Art starke, aber flexible Folie aus geeignetem Kunststoff ausgebildet sein, alternativ aus Glas.

In Ausgestaltung der Erfindung kann der Träger eine lichtundurchlässige Beschichtung aus einem Material aufweisen, das durch Bestrahlen mittels eines Lasers entfernt werden kann. Dabei kann eine solche Beschichtung auf der Oberseite des Trägers hin zu der Bedienblende vorgesehen sein. So können durch eine Art Maske die Leuchtanzeigen besonders gut dargestellt werden. In weiterer Ausgestaltung der Erfindung kann die Beschichtung zum Durchleuchten mit Lichtquellen wie LED entfernt sein, um gewünschte Symbole leuchtend anzuzeigen, vorteilhaft mittels Durchleuchten von hinten.

In Ausgestaltung der Erfindung kann unterhalb des Trägers ein Abstandshalter angeordnet sein, der flächig ausgedehnt ist, wobei dies bevorzugt in etwa entsprechend der Ausdehnung des Trägers und/oder eines Bauteilträgers sein kann, der unterhalb des Abstandshalters angeordnet ist und Leuchtmittel aufweist, vorteilhaft LED. Der Abstandshalter kann durchgehende Lichtkanäle aufweisen, unterhalb welchen oder in welchen die Leuchtmittel angeordnet sind. Die Lichtkanäle können zumindest teilweise eine Form aufweisen, die derjenigen der vorgenannten Maske mittels der lichtundurchlässigen Beschichtung entspricht. Der Bauteilträger kann zusätzlich zu den Leuchtmitteln auch elektronische Bauteile wie Microcontroller odgl. aufweisen, an welchen als Steuerung der Bedienvorrichtung eine Auswertung der Berührung durchgeführt werden kann.

In Ausgestaltung der Erfindung kann der Träger an seiner Unterseite eine Klebeschicht aufweisen zum Aufkleben auf ein darunter angeordnetes Teil, insbesondere auf den vorgenannten Abstandshalter. Die Klebeschicht kann mit einer Abdeckfolie abgedeckt sein, welche zur Montage abgezogen wird.

Ein erfindungsgemäßes Elektrogerät weist eine vorgenannte Bedienvorrichtung auf, wobei deren Bedienblende in eine Außenseite des Elektrogeräts eingesetzt ist oder einen Teil dieser Außenseite ist oder die vollständige Außenseite bildet. Das Elektrogerät kann beliebig sein, vorteilhaft eine Waschmaschine, ein Backofen, ein Kochfeld oder ein anderes Haushaltsgerät.

In Ausgestaltung der Erfindung ist das Elektrogerät ein Kochfeld mit einer Kochfeldplatte und Heizeinrichtungen an bzw. unter der Kochfeldplatte, wobei die Kochfeldplatte die Bedienblende bildet und insbesondere aus lichtdurchlässigem Material wie Glaskeramik oder Hartglas besteht. In diesem Fall ist der Bedienbereich direkt an der Kochfeldplatte gebildet, vorteilhaft an einem abgegrenzten bzw. bestimmten Bereich, und der Träger mit den Berührsensoren liegt an der Unterseite der Kochfeldplatte an.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte und Zwischen-Überschriften beschränkt die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im Folgenden näher erläutert. In den Zeichnungen zeigen:
- Fig. 1: eine seitliche Schnittdarstellung durch eine erfindungsgemäße Bedienvorrichtung in Explosionsdarstellung,
- Fig. 2: die Bedienvorrichtung aus Fig. 1 im zusammengesetzten Zustand,
- Fig. 3: eine Draufsicht auf einen Sensorträger der Bedienvorrichtung mit einer Vielzahl darauf verlaufender horizontaler und vertikaler Leiterbahnen als Sensoren,
- Fig. 4: eine Draufsicht auf einen alternativ ausgebildeten Sensorträger der Bedienvorrichtung mit einer Vielzahl darauf verlaufender Sensoren als spitze Zungen, und
- Fig. 5: eine Draufsicht auf ein erfindungsgemäßes Kochfeld mit einer erfindungsgemäßen Bedienvorrichtung.

### Detaillierte Beschreibung der Ausführungsbeispiele

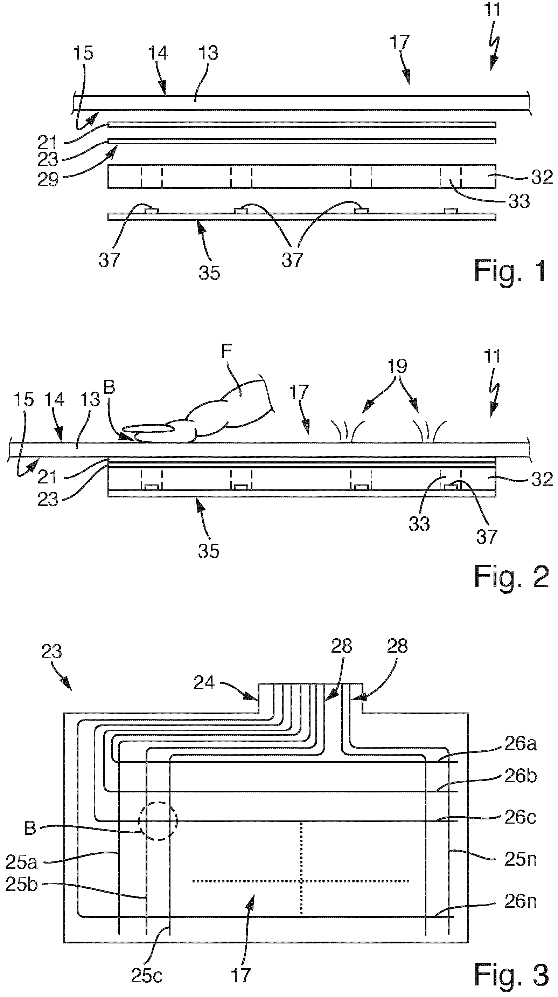

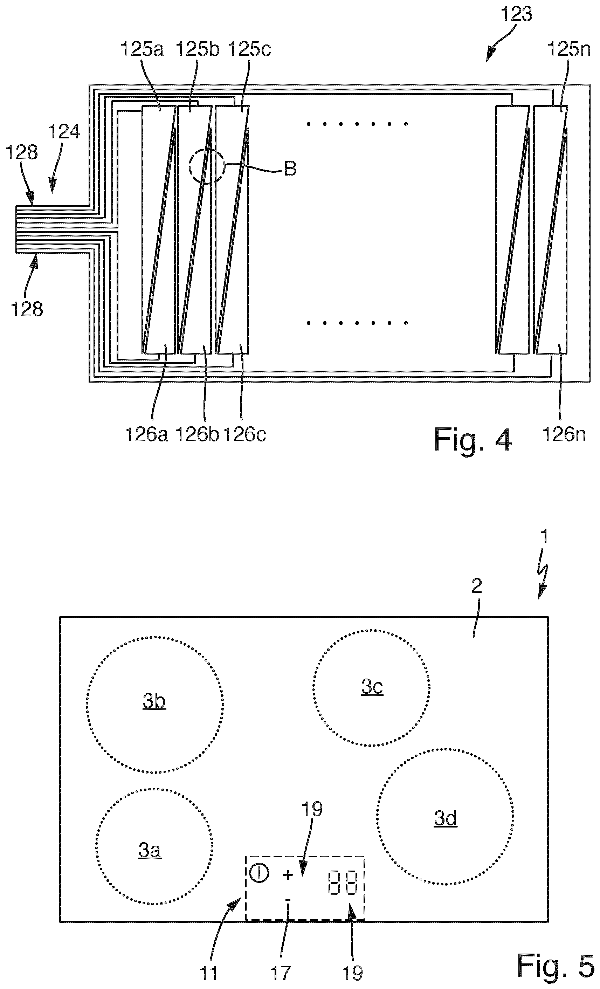

In der Fig. 1 ist eine erfindungsgemäße Bedienvorrichtung 11 mit einer Bedienblende 13 im Seitenschnitt in Explosionsdarstellung gezeigt. Diese Bedienvorrichtung 11 ist hier als einzelne Funktionseinheit dargestellt, die im zusammengesetzten Zustand gemäß Fig. 2 in ein eingangs genanntes allgemeines Elektrogerät eingebaut werden kann, beispielsweise in einen Backofen oder in das Kochfeld gem. Fig. 5. Alternativ kann die Bedienblende 13 durch eine Kochfeldplatte des Kochfelds gebildet sein, in die die Bedienvorrichtung 11 eingebaut ist. Dies ist aus dem eingangs genannten Stand der Technik ja bekannt.

Die genannte Bedienblende 13 der Bedienvorrichtung 11 weist eine Vorderseite 14 und eine Rückseite 15 auf. Wie die Fig. 2 zeigt, kann in einem an der Vorderseite 14 gebildeten Bedienbereich 17 ein Finger F aufgelegt werden zur Bedienung einer bestimmten Funktion des Elektrogeräts, in welchem die Bedienvorrichtung 11 verbaut ist. Der Finger F bildet auf der Vorderseite 14 der Bedienblende 13 eine Berührfläche B.

Eine Maske 21 ist unterhalb der Bedienblende 13 bzw. im zusammengebauten Zustand an deren Rückseite 15 angedrückt oder angeklebt. Diese Maske 21 ist grundsätzlich flächig lichtundurchlässig ausgebildet, weist aber lichtdurchlässige Ausschnitte oder Lichtdurchlässe auf in bestimmter Symbolform, wie dies aus dem Stand der Technik bekannt ist. Entweder können diese Ausschnitte rechteckig sein, um eine darunter angeordnete Sieben-Segment-Anzeige erkennen zu können. Alternativ können durch entsprechende Ausschnitte oder Lichtdurchlässe auch beleuchtbare Symbole als Leuchtanzeigen dargestellt werden, beispielsweise gem. Fig. 5 Möglichkeiten zur Leistungseinstellung oder ein Topf-Symbol für eine Anzeige einer Topferkennung odgl.. Die Maske 21 kann aus dünnem Kunststoff bestehen, wie dies an sich bekannt ist. Alternativ kann sie auch eine lichtundurchlässige Beschichtung sein, die vollflächig auf die Oberseite eines Sensorträgers 23 aufgebracht ist, wobei anschließend die gewünschten Symbole freigelegt sind durch Entfernen der Beschichtung. Als weitere Möglichkeit kann sie auch bereits mit Ausschnitten oder Lichtdurchlässen aufgebracht werden.

Der Sensorträger 23 wiederum besteht aus dünnem Kunststoff als eine Art stabile Kunststofffolie, alternativ aus dünnem Glas. Wie die Draufsicht der Fig. 3 auf den Sensorträger 23 zeigt, weist er im Wesentlichen rechteckige Form auf. An der in Fig. 3 nach oben weisenden Oberkante geht er in einen abstehenden Anschlussabschnitt 24 über, vorteilhaft einstückig. Auf dem Sensorträger 23 sind mehrere parallel verlaufende vertikale Leiterbahnen 25a bis 25n vorgesehen. Ihr Abstand zueinander kann im Bereich einiger Millimeter liegen, beispielsweise 5 mm, möglicherweise aber, abhängig von einer gewünschten Genauigkeit einer Auflösung, auch 8 mm oder sogar 10 mm bis 20 mm betragen. Die vertikalen Leiterbahnen 25a bis 25n enden am unteren freien Ende kurz vor einer unteren Kante des Sensorträgers 23. Oben gehen sie eng nebeneinander und mit zwei Abwinklungen nach oben zum Anschlussabschnitt 24, wo sie in streifenförmige Kontaktanschlüsse 28 übergehen. Diese können ggf. direkt durch angedrückte Kontakte oder durch einen aufgesteckten Kontaktstecker elektrisch kontaktiert werden.

In ähnlichem Abstand sind auf dem Sensorträger 23 im Bedienbereich 17 horizontale Leiterbahnen 26a bis 26n vorgesehen, die ebenfalls nach oben geführt sind auf den Anschlussabschnitt 24, wo sie Kontaktanschlüsse 28 bilden. Sie enden kurz vor der rechten Kante. Im Bedienbereich 17 kreuzen sich die Leiterbahnen 25 und 26 bzw. dort, wo sich diese kreuzen, ist der Bedienbereich definiert.

Wie der Fig. 3 zu entnehmen ist, kreuzen sich die vertikalen Leiterbahnen 25 und die horizontalen Leiterbahnen 26, allerdings jeweils nur ein einziges Mal, wobei jede Leiterbahn der einen Richtung alle anderen Leiterbahnen der anderen Richtung kreuzt. Die Leiterbahnen derselben Richtung sollten sich untereinander nicht kreuzen. Da der Sensorträger 23 lichtdurchlässig ausgebildet ist, sollten auch die Leiterbahnen 25 und 26 lichtdurchlässig ausgebildet sein, beispielsweise aus transparentem Zinnoxid oder anderen bekannten Materialien. Für die generelle Funktion der kapazitiven Berührsensoren dürfen sich die einzelnen elektrisch leitfähigen Leiterbahnen an keiner Stelle berühren bzw. sie müssen alle gegeneinander isoliert sein. Deswegen sollten die vertikalen Leiterbahnen 25 und die horizontalen Leiterbahnen 26 gegeneinander elektrisch isoliert sein bzw. keine Kurzschlüsse bilden. Dies kann durch dazwischen angeordnete Isolationsschichten erreicht werden, oder sie laufen in zwei unterschiedlichen Lagen oder tauchen an den Kreuzungspunkten unter der anderen Leiterbahn hindurch. Alternativ können beispielsweise die vertikalen Leiterbahnen 25 auf einer Oberseite des Sensorträgers 23 aufgebracht sein und die horizontalen Leiterbahnen 26 auf einer Unterseite des Sensorträgers 23. In einer Ausgestaltung sind die Leiterbahnen an den Kreuzungspunkten etwas flächiger ausgeführt, beispielsweise in Rautenform entsprechend des Längsverlaufs der entsprechenden Leiterbahn.

Gestrichelt dargestellt ist in der Fig. 3 eine Berührfläche B, die gemäß der Darstellung der Fig. 2 dadurch gebildet ist, dass der Finger F auf die Vorderseite 14 der Bedienblende 13 aufgelegt ist. Hier kann eine entsprechende Leuchtanzeige 19 vorgesehen sein. Aus der Fig. 3 ist zu erkennen, dass die Berührfläche B relativ nahe zum Kreuzungspunkt der vertikalen Leiterbahn 25c und der horizontalen Leiterbahn 26c liegt bzw. zu diesen beiden Leiterbahnen näher ist als zu den jeweils benachbarten. Somit kann hier entweder ein kapazitives Übersprechen zwischen den Leiterbahnen 25c und 26c am größten sein, was eine Steuervorrichtung der Bedienvorrichtung 11 oder des damit versehenen Elektrogeräts feststellen kann. Alternativ kann ermittelt werden, dass ein kapazitives Signal an der vertikalen Leiterbahn 25c und an der horizontalen Leiterbahn 26c am größten ist bzw. jeweils deutlich größer ist als bei den jeweils benachbarten Leiterbahnen. Dann wird nicht das kapazitive Übersprechen ausgewertet, sondern eine Signalstärke eines kapazitiven Signals. Dies ist aber jeweils im Stand der Technik bekannt. Jedenfalls bilden die Leiterbahnen 25 und 26 kapazitiv arbeitende Berührsensoren, entweder durch gemeinsames Arbeiten mit dem Auswerten eines kapazitiven Übersprechens, oder als kapazitive Sensoren, also sozusagen jeder für sich.

Unterhalb des Sensorträgers 23 ist ein eingangs genannter Abstandshalter 32 vorgesehen, beispielsweise bestehend aus lichtundurchlässigem Kunststoff. Für diesen Aufbau wird beispielhaft auf den Aufbau der deutschen Patentanmeldung DE 10 2024 120 882.1 derselben Anmelderin mit Anmeldetag vom 23. Juli 2024 verwiesen. In dem Abstandshalter 32 befinden sich mehrere durchgängige Lichtkanäle 33, vorteilhaft ausgebildet als einfache Ausschnitte oder Durchbrüche. Die Lichtkanäle 33 sind gepunktet dargestellt.

Unterhalb des Abstandshalters 32 befindet sich eine Leiterplatte 35 mit LED 37 an ihrer Oberseite. Der Abstandshalter 32 liegt oben auf der Leiterplatte 35 auf, so dass die LED 37 in die Lichtkanäle 33 hineinragen und nach oben leuchten, um die von oben erkennbaren Leuchtanzeigen 19 zu erzeugen.

Der Vorteil des Aufbaus des Sensorträgers 23 mit den vertikalen Leiterbahnen 25 und den horizontalen Leiterbahnen 26 im Vergleich zu diskret ausgebildeten kapazitiven Sensoren mit Sensorkörpern, wie sie beispielsweise aus der EP 0 859 467 A1, der DE 10 2015 214 008 A1 oder der DE 10 2016 206 174 A1 bekannt sind, besteht vor allem im verringerten Aufwand. Die Leiterbahnen 25 und 26 können in großer Zahl relativ einfach mit Beschichtungsverfahren auf den Sensorträger 23 aufgebracht werden. Der Abstandshalter 32 ist nur ein einziges Bauteil, welches schnell und einfach montiert ist. Ebenso können einfache und lichtstarke LED 37 verwendet werden.

Des Weiteren können Varianten der Bedienvorrichtung 11 relativ leicht hergestellt werden, indem die Maske 21 so ausgebildet ist, dass sie gelasert werden kann, um unterschiedliche Ausschnitte darin herzustellen. Alternativ kann eine lichtundurchlässige, entfernbare Schicht der Maske 21 auch auf einer der Seiten des Sensorträgers 23, vorteilhaft auf der Oberseite, vorgesehen sein. Der Sensorträger 23 wiederum kann mit einer Klebeseite 29 an der Unterseite leicht mit dem Abstandshalter 32 zu einer Baueinheit verklebt werden, die dann wiederum relativ leicht an der Leiterplatte 35 befestigt werden kann.

Wird eine solche Bedienvorrichtung 11 in ein Kochfeld integriert, so wird die Bedienblende 13 durch die Kochfeldplatte gebildet bzw. die Maske 21 wird mit ihrer Oberseite an eine Unterseite der Kochfeldplatte angedrückt, vorteilhaft federnd angedrückt.

In der Fig. 4 ist ein anders ausgebildeter Sensorträger 123 dargestellt, der im Wesentlichen auch rechteckig ist und einen nach oben abstehenden Anschlussabschnitt 124 aufweist. Auf dem Sensorträger sind länglich-schmale dreieckige Leiterbahnen als Beschichtung vorgesehen, die ggf. lichtdurchlässig sein und aus entsprechendem Material bestehen können. Von oben nach unten ragen Leiterbahnen 125a bis 125n. Von unten nach oben ragen Leiterbahnen 126a bis 126n, vorteilhaft genauso viele wie die Leiterbahnen 125. Diese Leiterbahnen 125 und 126 berühren sich nicht, auch nicht auf dem Weg zu dem Anschlussabschnitt 124, wo sie wiederum in Kontaktanschlüsse 128 übergehen.

Bei dieser Ausgestaltung der kapazitiven Sensoren 125 und 126 wird kein kapazitives Übersprechen durch eine Berührfläche B darüber erfasst, sondern die Signale benachbarter Sensoren bzw. Leiterbahnen 125 und 126 werden jeweils miteinander verglichen. Hier liegt die Berührfläche B erkennbar über den beiden Leiterbahnen 125b und 125c sowie über der Leiterbahnen 126b. Durch Vergleich der Signalstärke an allen drei genannten überdeckten Leiterbahnen kann ermittelt werden, wo genau die Berührfläche B im Bedienbereich 17 liegt.

In Fig. 5 ist ein erfindungsgemäßes Kochfeld 1 als Elektrogerät dargestellt, das eine Kochfeldplatte 2 und vier Heizeinrichtungen 3a bis 3d aufweist. Unten in der Mitte ist eine erfindungsgemäße Bedienvorrichtung 11 angeordnet, die hier gestrichelt dargestellt ist. Hier bildet die durchgängige Kochfeldplatte 2 die Bedienblende, auf welche ein Finger F aufgelegt werden kann.

Die Bedienvorrichtung 11 weist einen Bedienbereich 17 auf, in dem mehrere Leuchtanzeigen 19 vorgesehen sind, rechts eine Sieben-Segment-Anzeige und in der Mitte Möglichkeiten zur Leistungseinstellung einer der Heizeinrichtungen 3a bis 3d.

## Patentansprüche

1. Bedienvorrichtung für ein Elektrogerät, wobei die Bedienvorrichtung aufweist:
- eine flächig ausgebildete Bedienblende mit Vorderseite und Rückseite, wobei die Bedienblende zumindest teilweise lichtdurchlässig ist,
- einen Bedienbereich an der Bedienblende, in dem Berührsensoren angeordnet sind, die das Berühren an der Vorderseite der Bedienblende im Bedienbereich mittels eines Fingers an einer bestimmten Stelle erkennen,
- mindestens eine Leuchtanzeige im Bedienbereich unterhalb der Berührsensoren zur Anzeige eines Symbols oder möglichen Bedienbefehls, der durch Berühren der Vorderseite der Bedienblende mit dem Finger betätigt oder ausgewählt wird
**dadurch gekennzeichnet, dass**:
- die Berührsensoren kapazitive Berührsensoren sind, vorzugsweise nach dem Prinzip des kapazitiven Übersprechens oder als kapazitiver Berührsensor arbeitend ausgebildet sind,
- die Berührsensoren in einem Raster an der Rückseite der Bedienblende im Bedienbereich angeordnet sind.

2. Bedienvorrichtung nach Anspruch 1, **dadurch gekennzeichnet, dass** die Berührsensoren an einem flächigen Träger ausgebildet sind, insbesondere als Beschichtung bzw. als Leiterbahnen ausgebildet sind.

3. Bedienvorrichtung nach Anspruch 2, **dadurch gekennzeichnet, dass** die Beschichtung bzw. Leiterbahnen in zwei Gruppen aufgeteilt sind und die Beschichtung bzw. Leiterbahnen innerhalb jeder Gruppe jeweils parallel zueinander verlaufen, wobei die zwei Gruppen von Beschichtung bzw. Leiterbahnen in einem Winkel zwischen 60° und 120° zueinander verlaufen, insbesondere zwischen 85° und 95° zueinander.

4. Bedienvorrichtung nach Anspruch 2, **dadurch gekennzeichnet, dass** die Berührsensoren länglich ausgebildet sind und mit geringem Abstand nebeneinander verlaufen, wobei insbesondere die Berührsensoren in zwei Gruppen ausgebildet sind und abwechselnd parallel zueinander in entgegengesetzten Richtungen verlaufen, wobei sie von Leiterbahnen ausgehend länglich ausgebildet sind, vorzugsweise als längliche und spitz zulaufende Dreiecke.

5. Bedienvorrichtung nach einem der Ansprüche 2 bis 4, **dadurch gekennzeichnet, dass** der Träger einen Anschlussbereich aufweist, in dem die Leiterbahnen zum elektrischen Anschluss geführt sind, insbesondere an Anschlussfelder auf einer Seite des Trägers, wobei die Anschlussfelder freiliegen und/oder an einem Randbereich des Trägers angeordnet sind.

6. Bedienvorrichtung nach Anspruch 5, **dadurch gekennzeichnet, dass** der Anschlussbereich in einem Bereich des Trägers ausgebildet ist, der von dem Träger absteht, wobei vorzugsweise der Anschlussbereich rechteckig ausgebildet ist und als Rechteck von dem restlichen Träger absteht.

7. Bedienvorrichtung nach einem der Ansprüche 2 bis 6, **dadurch gekennzeichnet, dass** die Leiterbahnen einer Gruppe, vorzugsweise die Leiterbahnen beider Gruppen, einen Abstand zueinander zwischen 0,1 mm und 20 mm aufweisen, vorzugsweise zwischen 0,8 mm und 15 mm.

8. Bedienvorrichtung nach einem der vorhergehenden Ansprüche, **dadurch gekennzeichnet, dass** der Träger eine Dicke von weniger als 1 mm aufweist, vorzugsweise eine Dicke zwischen 0,05 mm und 0,2 mm.

9. Bedienvorrichtung nach einem der vorhergehenden Ansprüche, **dadurch gekennzeichnet, dass** der Träger eine lichtundurchlässige Beschichtung aufweist aus einem Material, das durch Bestrahlen mittels eines Lasers entfernbar ist, wobei vorzugsweise die Beschichtung auf der Oberseite des Trägers hin zu der Bedienblende vorgesehen ist.

10. Bedienvorrichtung nach Anspruch 9, **dadurch gekennzeichnet, dass** die Beschichtung entfernt ist zum Durchleuchten, um Symbole anzuzeigen.

11. Bedienvorrichtung nach einem der vorhergehenden Ansprüche, **dadurch gekennzeichnet, dass** unterhalb des Trägers ein Abstandshalter angeordnet ist, der flächig ausgedehnt ist entsprechend der Ausdehnung des Trägers und der durchgehende Lichtkanäle aufweist, wobei unterhalb des Abstandshalters ein Bauteilträger angeordnet ist mit Leuchtmitteln, die unterhalb oder in den Lichtkanälen angeordnet sind.

12. Bedienvorrichtung nach Anspruch 11, **dadurch gekennzeichnet, dass** der Träger an seiner Unterseite eine Klebeschicht aufweist, vorzugsweise mit einer Abdeckfolie abgedeckt, zum Aufkleben auf ein darunter angeordnetes Teil, insbesondere auf den Abstandshalter.

13. Elektrogerät mit einer Bedienvorrichtung nach einem der vorhergehenden Ansprüche, **dadurch gekennzeichnet, dass** die Bedienblende in eine Außenseite des Elektrogeräts eingesetzt ist oder Teil dieser Außenseite ist oder die vollständige Außenseite bildet.

14. Elektrogerät nach Anspruch 13, **dadurch gekennzeichnet, dass** es ein Kochfeld ist mit einer Kochfeldplatte und Heizeinrichtungen an der Kochfeldplatte, wobei die Kochfeldplatte die Bedienblende bildet und insbesondere aus lichtdurchlässigem Material wie Glaskeramik oder Hartglas besteht.
